# EUROPEAN PATENT APPLICATION

(11) **EP 1 965 448 A2**
(43) Date of publication of application: **03.09.2008**
(21) Application number: 08002681.8
(22) Date of filing: 13.02.2008
(51) Int. Cl.: H01L 41/09

(54) **Driving apparatus**

(30) Priority: 14.02.2007 JP 2007034077
(71) Applicant: Sharp Kabushiki Kaisha, Osaka-shi, Osaka 545-8522 (JP)
(72) Inventor: Nishioka, Sumito, Nara 636-0081 (JP)
(74) Representative: Müller - Hoffmann & Partner

(57) **Abstract**

To realize a driving apparatus where vibrational movement of a piezoelectric element is ensured; sufficient impact resistance is provided; and damages to the piezoelectric element is prevented, a driving apparatus of the present invention has: a flex movement member 1A or 1B for serving as a driving source to drive a lens barrel 4, the flex movement member including: a piezoelectric member 22X or 22Y which extends and contracts under electric control; and a shim 21 larger than the piezoelectric member 22X or 22Y, the piezoelectric member and the vibrational plate attached to each other; and protruding sections 8 for restricting an excessive flex movement of the shim 21 of the flex movement member 1A or 1B, the protruding sections 8 being at a position where the protruding sections 8 will not contact with the piezoelectric member 1A or 1B of the flex movement member 22X or 22Y when the flex movement member is making an excessive flex movement beyond a maximum flex movement amount, where the maximum flex movement amount is greatest among flex movement amounts necessary for the flex movement member 1A or 1B to drive the lens barrel 4. This provides the driving apparatus with enough impact resistance, and prevents damage to the piezoelectric element.

## Description

### FIELD OF THE INVENTION

The present invention relates to driving apparatuses containing a driving mechanism for driving a driven body.

### BACKGROUND OF THE INVENTION

Such a driving apparatus has been conventionally developed as contains a driving mechanism that drives a driven body by means of vibration of a piezoelectric element. According to the driving apparatus, the piezoelectric element is vibrated by use of voltage repeatedly applied to the piezoelectric element. Piezoelectric elements in general, which contain such a fragile material as ceramic, are breakable from deformation caused by a fall or a shock. To counter the problem, Patent Document 1 (Japanese Unexamined Patent Application Publication, *Tokukai,* No. 2004-254417; published on September 9, 2004), for example, discloses a piezoelectric actuator in which piezoelectric elements are attached to both sides of a reinforcing plate made of stainless steel or the like.

Further, as regards an art for improving impact resistance of an actuator not necessarily containing a piezoelectric element, Patent Document 2 (Japanese Unexamined Patent Application Publication, *Tokukai,* No. 2006-251728; published on September 21, 2006), for example, discloses an arrangement which includes movement suppressing means for suppressing movement of a holder that holds a lens or the like.

However, the following problems arise from the arrangements disclosed in the above Patent Documents 1 and 2.

In the case of a driving apparatus having the arrangement disclosed by Patent Document 1, vibrational movement of the piezoelectric element becomes small when the reinforcing plate is thickened for the purpose of improving impact resistance of the piezoelectric element. Further, in order to make large vibrational movement and thereby to drive a driven body efficiently, a particular type of arrangement is required in which the reinforcing plate is either thinned, or attached only to a part of the piezoelectric element. However, the arrangement does not ensure sufficient impact resistance.

Furthermore, in the case of the arrangement that includes movement controlling means for controlling movement of a holder as described in Patent Document 2, the movement controlling means collides with the piezoelectric element. The collision may in turn break the fragile piezoelectric element.

### SUMMARY OF THE INVENTION

The present invention was accomplished in view of the above problems. It is an object of the present invention to realize a driving apparatus in which; vibrational movement of a piezoelectric element is ensured; sufficient impact resistance is provided; and the piezoelectric element is prevented from being broken.

In order to attain the object, a driving apparatus according to the present invention is a driving apparatus for driving a driven body, comprising a flex movement member for serving as a driving source to drive the driven body, the flex movement member including: a piezoelectric member which extends and contracts under electric control; a vibrational plate which is larger than the piezoelectric member, the piezoelectric member and the vibrational plate being attached to each other; and movement restricting means for restricting an excessive flex movement of the vibrational plate of the flex movement member, the movement restricting means being disposed at a position where the movement restricting means will not come into contact with the piezoelectric member of the flex movement member when the flex movement member is making an excessive flex movement beyond a maximum flex movement amount, where the maximum flex movement amount is a greatest flex movement amount among flex movement amounts necessary for the flex movement member to drive the driven body.

According to the above arrangement, the movement restricting means restricts flex movement of the vibrational plate in the flex movement member in the case where the flex movement member bends beyond the maximum flex movement amount. This makes it possible to prevent the flex movement member from being deformed and thereby broken, in the case where the flex movement member bends beyond the maximum flex movement amount due to a collision or the like.

Further, the movement restricting means is disposed so as not to come into contact with the piezoelectric member in the flex movement member in the case where the flex movement member bends beyond the maximum flex movement amount. As a result, the piezoelectric member does not come into contact with the movement restricting means, in the case where the flex movement member bends beyond the maximum flex movement amount due to a collision or the like. Therefore, the above arrangement makes it possible to prevent the piezoelectric member from being broken.

As described so far, according to the above arrangement, it is possible to realize a driving apparatus in which; vibrational movement of the piezoelectric element is ensured; sufficient impact resistance is provided; and the piezoelectric element is prevented from being broken.

Additional objects, features, and strengths of the present invention will be made clear by the description below. Further, the advantages of the present invention will be evident from the following explanation in reference to the drawings.

### BRIEF DESCRIPTION OF THE DRAWINGS

Fig. 1 is a perspective view showing an arrangement of the driving apparatus according to an embodiment of the present invention.
Fig. 2 (a) is a side view showing positional relationships among a flex movement member, an elastic member and a frictional member, each contained in the driving apparatus illustrated in Fig. 1.
Fig. 2 (b) is a plan view showing the arrangement of the driving apparatus illustrated in Fig. 1.
Fig. 3 is a perspective view showing an arrangement of a driving apparatus according to another embodiment of the present invention.
Fig. 4 is a perspective view showing an arrangement of a driving apparatus according to still another embodiment of the present invention.
Fig. 5 (a) is a side view showing an arrangement of a bimorph piezoelectric element.
Fig. 5 (b) shows how the piezoelectric element exhibits flex movement.
Fig. 6 is a diagram showing exemplary waveforms of driving voltages applied to two flex movement members.
Fig. 7 (a) is a diagram explaining how an end section of the frictional member is driven to oval movement in accordance with the driving voltage waveforms illustrated in Fig. 6.
Fig. 7 (b) is a diagram explaining how the end section of the frictional member is driven to oval movement in accordance with the driving voltage waveforms illustrated in Fig. 6.
Fig. 7 (c) is a diagram explaining how the end section of the frictional member is driven to oval movement in accordance with the driving voltage waveforms illustrated in Fig. 6.
Fig. 8 is a diagram showing exemplary waveforms of driving voltages applied to two flex movement members.
Fig. 9 (a) is a diagram explaining how an end section of the frictional member is driven to arc movement in accordance with the driving voltage waveforms illustrated in Fig. 8.
Fig. 9 (b) is a diagram explaining how the end section of the frictional member is driven to arc movement in accordance with the driving voltage waveforms illustrated in Fig. 8.

### DESCRIPTION OF THE EMBODIMENTS

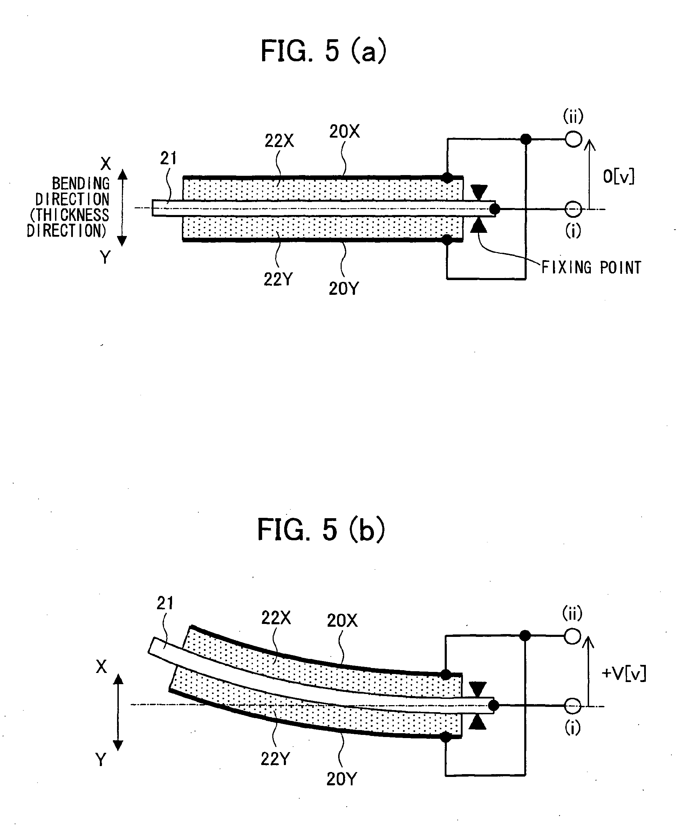

The driving apparatus of the present invention includes a flex movement member and controlling means for electronically controlling flex movement of the flex movement member. According to the present driving apparatus, the flex movement member exhibits flex movement when excited by means of electronic control of the controlling means. Explained first is the flex movement member that exhibits flex movement when excited by means of electronic control. A bimorph piezoelectric element illustrated in Figs. 5 (a) and 5 (b) is an exemplary flex movement member.

Fig. 5 (a) is a side view showing an arrangement of a bimorph piezoelectric element. Fig. 5 (b) shows how the piezoelectric element exhibits flex movement.

The piezoelectric element illustrated in Figs. 5 (a) and 5 (b) includes two piezoelectric material layers 22X and 22Y and a shim (a vibrational plate) 21 which is made of metal. The piezoelectric element has a pressure-attached three-layer structure in which the shim 21 is sandwiched between the two piezoelectric material layers 22X and 22Y. Two electrodes 20X and 20Y further sandwich the three-layer structure. The two electrodes 20X and 20Y are connected with the controlling means (not shown). Furthermore, one end of the shim 21 is fixedly supported (see "fixing point" indicated by black triangle marks in Figs. 5 (a) and 5 (b)). The direction in which the layers are built in the three-layer structure formed from the piezoelectric material layers 22X and 22Y and the shim 21 is referred to as a thickness direction in Figs. 5 (a) and 5 (b). With regard to the thickness direction, the direction toward the piezoelectric material layer 22X is referred to as the X direction, and the direction toward the piezoelectric material layer 22Y is referred to as the Y direction.

The piezoelectric element illustrated in Figs. 5 (a) and 5 (b) is set so as to bend in the thickness direction when voltage is applied to the electrodes 20X and 20Y by the controlling means.

The piezoelectric material layer 22X is, for example, polarized so as to: contract when the voltage between the electrode 20X and the shim 21 becomes positive; and extend when the voltage between the electrode 20X and the shim 21 becomes negative. Comparatively, the piezoelectric material layer 22Y is polarized so as to: extend when the voltage between the electrode 20Y and the shim 21 becomes positive; and contract when the voltage between the electrode 20Y and the shim 21 becomes negative.

Explained now is the case in which voltage is applied by the controlling means to the piezoelectric material layers 22X and 22Y polarized as above. As illustrated in Fig 5. (b), the controlling means applies positive voltage between the electrodes 20X and 20Y, and the shim 21 (i.e. between (i) and (ii) in Fig. 5 (b)). The shim 21 is fixed at the point indicated by the black triangle marks. In this case, as Fig. 5 (b) shows, the piezoelectric element bends in the X thickness direction. In contrast, in the case where the controlling means applies negative voltage between (i) and (ii), the piezoelectric element bends in the Y thickness direction (not shown).

As described above, the piezoelectric element illustrated in Figs. 5 (a) and 5 (b) is set so as to bend in response to the voltage applied by the controlling means. It should be noted that the flex movement member contained in the driving apparatus of the present invention is not limited to the piezoelectric element illustrated in Figs. 5 (a) and 5 (b), and may be any member having a structure in which flex movement can be controlled electronically. For example, a monomorph piezoelectric element which includes one piezoelectric material layer and a shim can be used as a flex movement member. The workings of a monomorph piezoelectric element are substantially the same as the workings of a bimorph piezoelectric element. Thus, the monomorph piezoelectric element can be bent under electric control.

As described above the flex movement member contained in the driving apparatus of the present invention refers to any member that can be bent under electric control such as application of voltage. The structure of the flex movement member is not subject to any limit in terms of measurements such as thickness, length and width or shapes.

Hereafter, the flex movement member which exhibits flex movement when excited by electric control is simply termed "the flex movement member", for the sake of easy explanation.

Further, in the present specification, in the case where the flex movement member is disposed inside the driving apparatus, (a) the direction in which the driven body moves is termed the driven body moving direction or the width direction (of the flex movement member), (b) the direction in which the flex movement member bends is termed the bending direction or the thickness direction (of the flex movement member), and (c) the direction which extends orthogonally to the driven body moving direction (i.e. the width direction) and to the bending direction (i.e. the thickness direction) is termed the length direction (of the flex movement member). These terms are not subject to the measurements of the flex movement member or the location of the fixed point of the flex movement member.

### [First Embodiment]

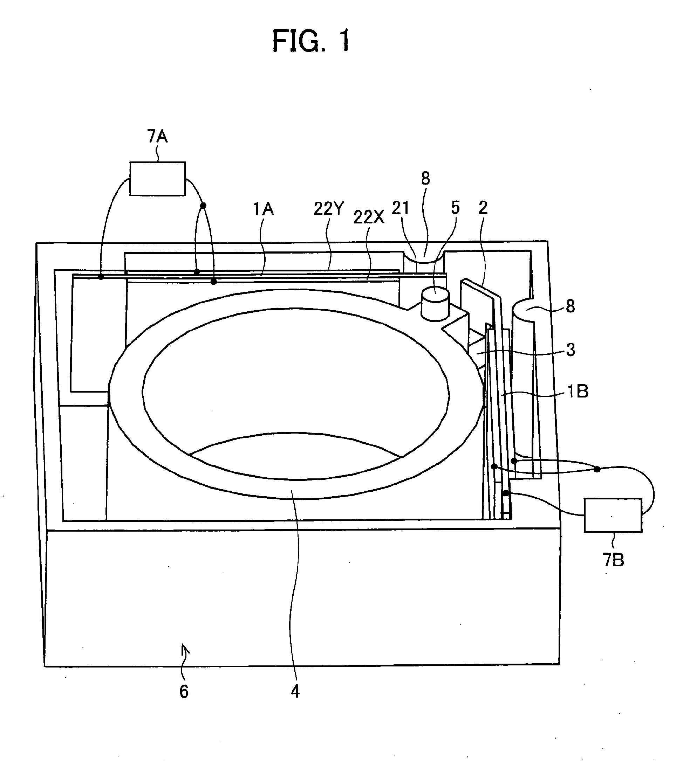

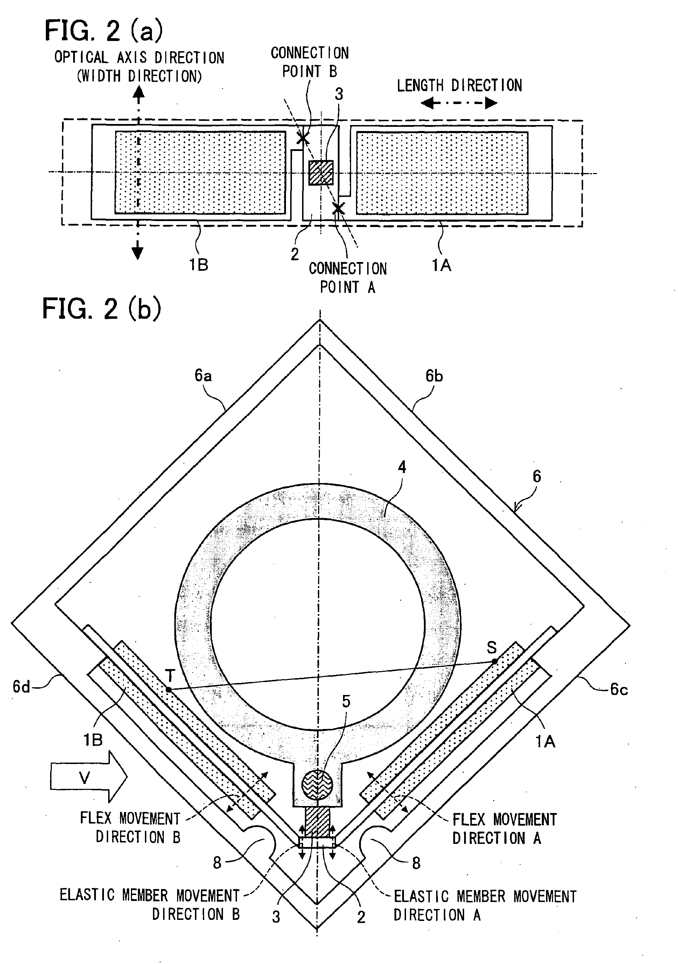

One embodiment of the present invention will be explained below with reference to Figs. 1, 2 (a) and 2(b). Fig. 1 is a perspective view showing an arrangement of the driving apparatus (hereinafter referred to as the present driving apparatus) according to the present embodiment. The driving apparatus illustrated in Fig. 1 is an embodiment most preferably applicable to a focus adjusting mechanism of a compact camera module.

First, as illustrated in Fig. 1, the present driving apparatus includes flex movement members 1A and 1B, an elastic member 2, a frictional member 3, a lens barrel (a driven body) 4, a guide shaft 5, a camera module housing (a support member) 6, driving circuits (controlling means) 7A and 7B, and protruding sections 8 (first protruding sections; movement restricting means).

According to the present driving apparatus, the elastic member 2 connects the flex movement members 1A and 1B. Further connected with the elastic member 2 is the frictional member 3 that is engaged in friction contact with the lens barrel 4.

The flex movement members 1A and 1B are bimorph piezoelectric elements having a pressure-attached three-layer structure in which the shim 21 is sandwiched between the aforementioned piezoelectric material layers 22X and 22Y. Further, as illustrated in Fig. 1, one end (an extension of the shim, according to the present embodiment) of the flex movement members 1A and 1B is fixedly attached to the camera module housing 6 by adhesion, fitting-in, or the other method. The other end is connected with the elastic member 2.

The elastic member 2 is made of a material having low elasticity such as metal or resin. Further, according to the present driving apparatus, the lens barrel 4 is set so as to move in an optical axis direction when the frictional member 3 is engaged in (friction) contact with the lens barrel 4. Therefore, the material for the frictional member 3 may be metal, resin, carbon fiber or the like, and is determined in accordance with the desired coefficient of friction with the lens barrel 4.

Further provided in the present driving apparatus is the guide shaft 5 that guides the lens barrel 4 along the optical axis direction. Provided in the lens barrel 4 is a hole section through which the guide shaft 5 is inserted. The guide shaft 5 is a pole-like member extending in the optical axis direction, and is fixed to a bottom section (or a top section) of the camera module housing 6. The guide shaft 5 further serves to support the lens barrel 4 so that the frictional member 3 is engaged in friction contact with the lens barrel 4. According to the present driving apparatus, the lens barrel 4 is set so as to move in the optical axis direction along the guide shaft 5 when the frictional member 3 is engaged in friction contact with the lens barrel 4. It should be noted that, according to the present driving apparatus, the lens barrel 4 does not necessarily incorporate a hole section through which the guide shaft 5 is inserted. Alternatively, a separate hole member having a hole section may be attached to the lens barrel. Furthermore, another arrangement may also be possible in which a friction adjusting member for gaining a desired coefficient of friction is connected (or glued) to the lens barrel 4 at the point of friction engagement with the frictional member 3. Therefore, the lens barrel in the present embodiment encompasses an arrangement in which the above hole member and/or the friction adjusting member is/are provided.

The flex movement members 1A and 1B are connected with the driving circuits 7A and 7B respectively. The driving circuit 7A excites the flex movement member 1A by applying voltage or the like thereto so that the flex movement member 1A exhibits flex movement. The driving circuit 7B excites the flex movement member 1B by applying voltage or the like thereto so that the flex movement member 1B exhibits flex movement. The driving circuits 7A and 7B are controlled by a superordinate controlling circuit (not shown), and output voltage corresponding to a driving waveform described below to the flex movement members 1A and 1B. It should be noted that the "controlling means" refers to means which includes the driving circuits 7A and 7B and the superordinate controlling circuit.

Electric control of flex movement of the flex movement members 1A and 1B is not necessarily performed by the use of voltage. For example, in the case where the flex movement members 1A and 1B are formed from bimetal or shape-memory alloy and excited to exhibit flex movement by means of heat, electric control of flex movement of the flex movement members 1A and 1B is performed by increasing or decreasing current. In this case, the heat generated by part of the flex movement members 1A and 1B is controlled by increasing or decreasing current flowing through the flex movement members 1A and 1B. As a result, temperatures of the flex movement members 1A and 1B can be controlled. Alternatively, in the proximity of the flex movement members 1A and 1B, heat generating means may be provided which is formed from a heating wire such as a Nichrome wire or a kanthal wire and generates heat when current passes therethrough. The heat generated by the heat generating means is controlled by increasing or decreasing the current flowing through the heat generating means. As a result, temperatures of the flex movement members 1A and 1B can be controlled. Furthermore, in the case where the flex movement members 1A and 1B are formed, for example, from a magnetostrictor and excited to exhibit flex movement by means of a magnetic field, magnetic field generating means is provided such as an electromagnet which generates a magnetic field when current is provided. The magnetic field applied to the flex movement members 1A and 1B is controlled by increasing or decreasing the current.

Further, an optical element such as a lens or the like is set in the lens barrel 4 (not shown in Fig. 1). Disposed in the bottom section of the lens barrel 4 is an image sensor such as a CCD.

According to the present driving apparatus, the lens barrel 4 is driven to move along the guide shaft 5 by the use of the driving mechanism composed of the flex movement members 1A and 1B, the elastic member 2 and the frictional member 3. By means of the driving mechanism, the optical element set in the lens barrel 4 is driven to move in the optical axis direction, and focus adjustment is thereby made. Further, according to the present embodiment, the driven body moving direction in which the lens barrel moves is synonymous with the optical axis direction. According to the present specification, the direction toward which the optical element set in the lens barrel 4 images an object (i.e. the direction of a straight line that connects the lens barrel 4 and the object) is termed the "optical axis direction".

The camera module housing 6 encases the flex movement members 1A and 1B, the elastic member 2, the frictional member 3, the lens barrel 4 and the guide shaft 5. According to the present driving apparatus, the camera module housing 6 is a rectangular parallelepiped in shape and has side walls 6a to 6d. As illustrated in Fig. 2 (b), the flex movement members 1A and 1B are disposed along the side walls 6c and 6d of the camera module housing 6. Further, the flex movement members 1A and 1B are arranged so that, among straight lines which connect (i) a random point (e.g. the point S illustrated in Fig. 2 (b)) on the flex movement member 1A and (ii) another random point (e.g. the point T illustrated in Fig. 2 (b)) on the flex movement member 1B, at least one straight line (e.g. the straight line connecting the points S and T) can be drawn so as to pass through the lens barrel 4. Further, the elastic member 2 and the frictional member 3 are disposed in the corner formed by the flex movement members 1A and 1B.

As described above, according to the present driving apparatus, the flex movement members 1A and 1B are disposed along the side walls of the camera module housing 6, and the elastic member 2 and the frictional member 3 are disposed in the corner having ample space. Consequently, the space in the camera module housing 6 can be used efficiently for disposition of the driving mechanism, and the driving apparatus can thereby be made compact.

In order to drive the lens barrel 4, the flex movement members 1A and 1B need to have a flex movement amount which falls within a certain range. When, among such flex movement amounts, the maximum movement degree is termed a maximum flex movement amount, the present driving apparatus is arranged such that the protruding sections 8 are disposed so as to restrict the movement of the shims 21 of the flex movement members 1A and 1B in the case where the flex movement members 1A and 1B bend beyond the maximum flex movement amount.

The protruding sections 8 are formed on the interior side walls of the camera module housing 6 supporting the flex movement members 1A and 1B. The protruding sections 8 are disposed in correspondence with each of the flex movement members 1A and 1B and protrude from interior side walls of the camera module housing 6 toward the flex movement members 1A and 1B.

In the case where the flex movement member (1A or 1B) bends beyond the maximum flex movement amount, the corresponding protruding section 8 comes into contact with the shim 21 of the flex movement member (1A or 1B). Flex movement of the flex movement members 1A and 1B is thereby restricted so that the flex movement members 1A and 1B do not exhibit excessive flex movement. In other words, the protruding sections 8 are means which prevent the flex movement members 1A and 1B from being deformed and thereby broken, in the case where the flex movement members 1A and 1B are displaced to a large degree due to a collision or the like. Furthermore, when the flex movement amount up to which the flex movement members 1A and 1B by themselves can tolerate (i.e. the flex movement amount up to which the flex movement members 1A and 1B are not breakable from) is termed a tolerable flex movement amount, the protruding sections 8 are disposed so as to restrict flex movement of the vibrational plates having a movement amount lower than the tolerable flex movement amount so that the vibrational plates do not exhibit excessive flex movement. Consequently, the movement restricting sections 8 come into contact with the shims 21 of the flex movement members 1A and 1B before flex movement of the flex movement members 1A and 1B reaches the tolerable flex movement amount.

The "maximum flex movement amount", as described above, refers to the maximum movement degree among the flex movement amounts of the flex movement members 1A and 1B one of which degrees is necessary to drive the lens barrel 4. In other words, the maximum flex movement amount refers to the maximum movement degree among the flex movement amounts one of which degrees is necessary to drive the lens barrel 4, in the case where the flex movement members 1A and 1B are in practical use as a driving source for the driving apparatus. The maximum flex movement amount is suitably determined with respect to the driving force of the lens barrel 4, the size of the flex movement members 1A and 1B or the size of the lens barrel 4.

Further, the "tolerable flex movement amount" refers to the movement degree up to which the flex movement members 1A and 1B by themselves can tolerate, and is determined in accordance with the flex movement properties of the flex movement members 1A and 1B themselves. In other words, the "tolerable flex movement amount" is a property of the flex movement members 1A and 1 B and is independent of the arrangement of the driving apparatus. Hence, the "tolerable flex movement amount" is suitably determined with respect to the structure (e.g. whether the structure is a bimorph structure or a monomorph structure) of the flex movement members 1A and 1B.

Driving apparatus are generally arranged such that the lens barrel 4 can be driven with flex movement amounts below the tolerable flex movement amount. This is because the flex movement members 1A and 1B become broken when the flex movement reaches the tolerable flex movement amount or beyond. Thus, according to the present driving apparatus, the "maximum flex movement amount" is set lower than the "tolerable flex movement amount".

The protruding sections 8 serve as the movement restricting means in the present driving apparatus. The protruding sections 8 restrict the flex movement members 1A and 1B so that the flex movement members 1A and 1B do not bend beyond the "tolerable flex movement amount". Therefore, the protruding sections 8 are disposed so as: not to come into contact with the shims 21 when the flex movement of the flex movement members 1A and 1B reaches the maximum flex movement amount; and to come into contact with the shims 21 before the flex movement of the flex movement members 1A and 1B reaches the tolerable flex movement amount after exceeding the maximum flex movement amount.

Furthermore, the protruding sections 8 are disposed so as: not to come into contact with the piezoelectric member 22Y; and to come into contact with the shims 21, in the case where the flex movement members 1A and 1B are displaced to a large extent beyond the maximum flex movement amount due to impact caused by a collision or the like. This makes it possible to prevent the piezoelectric member 22Y, which is made of relatively fragile ceramic and contained in the flex movement members 1A and 1B, from coming into contact with the protruding sections 8. As a result, the piezoelectric member can be prevented from being broken by impact caused by a collision or the like.

Still further, the protruding sections 8 are incorporated in the camera module housing 6. As a result, the flex movement members 1A and 1B and the movement restricting means 8 can be positioned accurately with respect to each other. Thus, positioning of the flex movement members 1A and 1B and the protruding sections 8 can be facilitated.

As illustrated in Fig. 1, the protruding sections 8 are semi-cylindrical in shape. However, the shape of the protruding sections 8 is not limited to a semi-cylinder, and may be any shape that can come into contact with the shim 21.

Further, according to the arrangement illustrated in Fig. 1, the protruding sections 8 serving as the movement restricting means are provided on the interior side walls of the camera module housing 6. However, according to the present driving apparatus, the arrangement or the position of the "movement restricting means" is not limited to the present embodiment as long as the "movement restricting means" have the function of restricting excessive flex movement of the vibrational plates contained in the flex movement members. For example, the "movement restricting means" can be formed by interior wall surfaces of the camera module housing 6. Specifically, the interior wall surfaces of the camera module housing 6 are positioned with respect to the flex movement members 1A and 1B so as: not to come into contact with the shims 21 when the flex movement of the flex movement members 1A and 1B reaches the maximum flex movement amount; and to come into contact with the shims 21 before the flex movement of the flex movement members 1A and 1B reaches the tolerable flex movement amount after exceeding the maximum flex movement amount. As a result, the interior wall surfaces of the camera module housing 6 can function as the movement restricting means. In other words, in the case where the supporting positions of the flex movement members 1A and 1B are optimized as described above, instead of the protruding sections 8 illustrated in Fig. 1, the interior wall surfaces of the camera module housing 6 can be used as the movement restricting means.

According to the present driving apparatus, the flex movement members 1A and 1B, the elastic member 2 and the frictional member 3 are arranged so that the lens barrel 4 is driven to move in the direction orthogonal to the flex movement direction of the flex movement members 1A and 1B. The following explains positional relationships among the flex movement members 1A and 1B, the elastic member 2 and the frictional member 3 as well as the principle of driving operation of the lens barrel 4 in accordance with the present driving apparatus.

### [Positional Relationships]

Fig. 2 (a) is a side view showing positional relationships among the flex movement members 1A and 1B, the elastic member 2 and the frictional member 3, in the present driving apparatus. Fig. 2 (b) is a plan view showing the arrangement of the present driving apparatus. As illustrated in Fig. 2 (a), the point at which the flex movement member 1A and the elastic member 2 are connected is termed a connection point A (shown by an X mark in Fig. 2 (a)), whereas the point at which the flex movement member 1B and the elastic member 2 are connected is termed a connection point B (shown by an X mark in Fig. 2 (a)). Further, the line that is parallel with the length direction and extends through the centers of the flex movement members 1A and 1B is termed an imaginary line L1. The imaginary line L1 passes through the frictional member 3.

As illustrated in Fig. 2 (a), the flex movement members 1A and 1B are disposed adjacent to each other along the imaginary line L1. In other words, the flex movement members 1A and 1B are arranged so that (a) a line that is parallel with the length direction and extends through the center of the flex movement member 1A; and (b) a line that is parallel with the length direction and extends through the center of the flex movement member 1 B, both lie on the imaginary line L1.

Further, the connection points A and B are positioned so that an imaginary line AB connecting the two points intersects the imaginary line L1. Also, as Fig. 2 (a) shows, the connection point A is positioned above the imaginary line L1, whereas the connection point B is positioned below the imaginary line L1.

Furthermore, as Fig. 2 (b) shows, the flex movement member 1A is displaced in a direction which is designated by the arrow and termed a flex movement direction A. Subsequently, the elastic member 2 is excited, so that a movement vector is generated at the connection point A of the elastic member 2 in a direction that is designated by an arrow and termed an elastic member movement direction A. Yet further, the flex movement member 1B is displaced in a direction that is designated by the arrow and termed a flex movement direction B. Subsequently, the elastic member 2 is excited, so that a movement vector is generated at the connection point B of the elastic member 2 in a direction that is designated by an arrow and termed an elastic member movement direction B. (In other words, movement vectors are generated at the points A and B in Fig. 2 (a) in a direction orthogonal to the figure surface.) Other movement vectors are generated at the connection points A and B in directions other than the directions described above. However, these movement vectors will not be explained because the relationship between the movement vectors and the driving is insignificant.

The following explains in accordance with the present driving apparatus waveforms of the driving voltages supplied from the controlling means that includes the driving circuits 7A and 7B, and the principle of driving operation of the lens barrel 4 that moves in the optical axis direction in response to the waveforms of the driving voltages.

### [Principle of Operation 1]

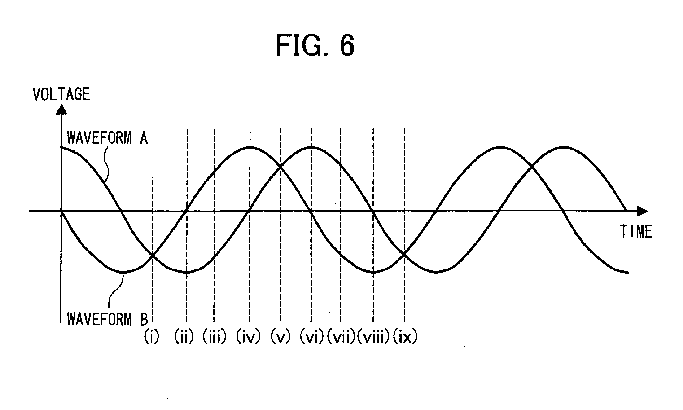

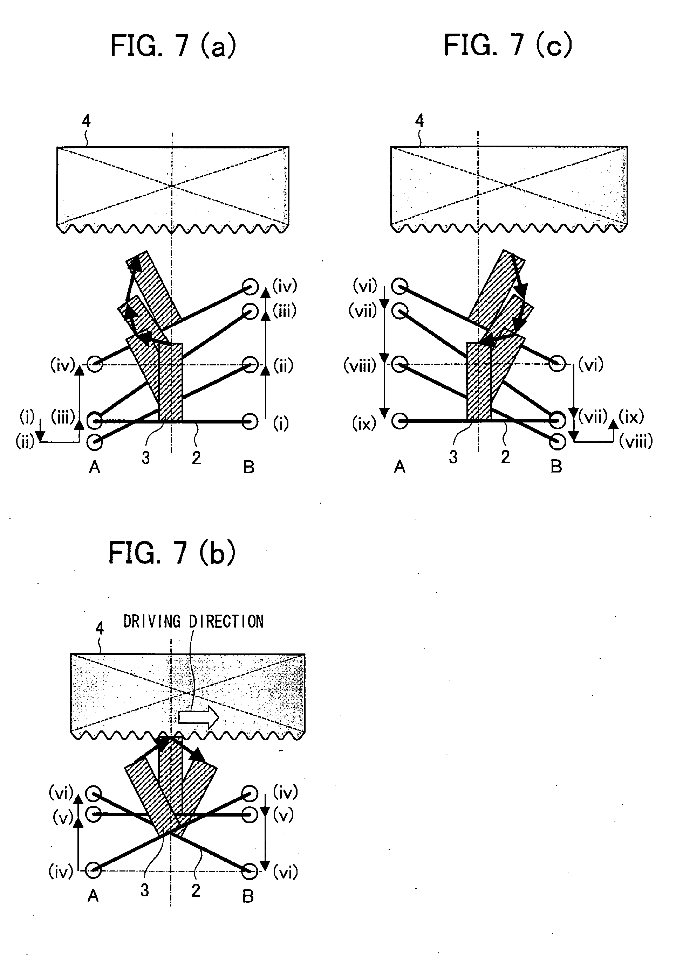

Explained first is an exemplary operation of driving the lens barrel 4, by use of the frictional member 3, to move in the optical axis direction. According to the foregoing operation, an end (i.e. the part in friction engagement with the lens barrel 4) of the frictional member 3 is driven to oval movement. Fig. 6 is a diagram showing exemplary waveforms of the driving voltages applied to the two flex movement members 1A and 1B. Figs. 7 (a) to 7 (c) are diagrams explaining how the end section of the frictional member 3 is driven to move along the oval shape in accordance with the driving voltage waveforms illustrated in Fig. 6. Figs. 7 (a) to 7 (c) show the present driving apparatus viewed in a direction represented by the arrow Y of Fig. 2 (b).

According to Fig. 6, the waveform of the driving voltage applied to the flex movement member 1A is termed a waveform A, whereas the waveform of the driving voltage applied to the flex movement member 1B is termed a waveform B. Additionally, the driving voltage waveforms A and B are outputted from the driving circuits 7A and 7B respectively. As illustrated in Fig. 6, the waveforms A and B take the shape of a sine wave, and are such the signal waveforms whose phases are shifted by 90 degrees from each other. Figs. 7 (a) to 7 (c) show the positions of the connection points A and B with respect to moments (i) to (ix) in the waveforms A and B illustrated in Fig. 6.

As illustrated in Figs. 7 (a) to 7 (c), when the flex movement members 1A and 1B are driven in accordance with the waveforms A and B, the connection points A and B are shifted in the numerical order from (i) to (ix). Specifically, the connection points A and B lie: in the position (i) of Fig. 7 (a) at the moment (i) of Fig. 6; in the position (ii) of Fig. 7 (a) at the moment (ii) of Fig. 6; in the position (iii) of Fig. 7 (a) at the moment (iii) of Fig. 6; in the position (iv) of Figs. 7 (a) and 7 (b) at the moment (iv) of Fig. 6; in the position (v) of Fig. 7 (b) at the moment (v) of Fig. 6; in the position (vi) of Figs. 7 (b) and 7 (c) at the moment (vi) of Fig. 6; in the position (vii) of Fig. 7 (c) at the moment (vii) of Fig. 6; in the position (viii) of Fig. 7 (c) at the moment (viii) of Fig. 6; and in the position (ix) of Fig. 7 (c) at the moment (ix) of Fig. 6. Since the connection points A and B are shifted through the transition from (i) to (ix) illustrated in Figs. 7 (a) to 7 (c), the end section of the frictional member 3 is driven to move along the oval shape as illustrated in Figs. 7 (a) to 7 (c). When the movement direction in which the end section of the frictional member 3 is shifted when the frictional member 3 is in contact with the lens barrel 4 is termed the driving direction, the lens barrel 4 is driven by the scratch of the frictional member 3 in the driving direction, which direction is determined by the direction in which the end section turns.

According to the example illustrated in Figs. 6 and 7 (a) to 7 (b), the end of the frictional member 3 is arranged so as to alternately come into contact with and come off the lens barrel 4 due to the rotational movement (i.e. since the end of the frictional member 3 is driven to make the oval movement). However, the present invention is not limited to the example described above.

The present driving apparatus can employ an arrangement in which the end of the frictional member 3 is in constant contact with the lens barrel 4. For example, by employing a spring as the elastic member 2, the frictional member 3 can be pressed against the lens barrel 4 with use of the spring. Alternatively, the flex movement members 1A and 1B can be fixedly positioned closer to the lens barrel 4 (i.e. in the direction of the driven body) to a predetermined extent. Further alternatively, the guide shaft 5 can be fixed so that the lens barrel 4 is pressed against the frictional member 3. According to the arrangements described above, the end of the friction member 3 is positioned so as to be in constant contact with the lens barrel 4 due to the advance pressure.

Furthermore, according to the arrangements, the frictional member 3 is excited so that the end thereof is linearly shifted, alternately in the driving direction and in the reverse direction (i.e. the reverse driving direction) instead of turning along the oval shape. (In this case, the flex movement members 1A and 1B, the elastic member 2, the frictional member 3 and the like are distorted.) The levels of pressure applied by the frictional member 3 against the lens barrel 4 are naturally different between (a) the period when the end of the frictional member 3 is shifted in the driving direction and (b) the period when the end of the frictional member 3 is shifted in the reverse driving direction. More specifically, the pressure that the end of the frictional member 3 applies against the lens barrel 4 becomes high when the end of the frictional member 3 is shifted in the driving direction, whereas the pressure that the end of the frictional member 3 applies against the lens barrel 4 becomes low when the end of the frictional member 3 is shifted in the reverse driving direction.

As a result, a difference is generated in static friction between the frictional member 3 and the lens barrel 4. This makes it possible to adjust the coefficient of friction and the advance pressure of the frictional member 3 so that (a) the end of the frictional member 3 does not slide on the lens barrel 4 when the lens barrel 4 is rotated in the driving direction and (b) the end of the frictional member 3 does slide on the lens barrel 4 when the lens barrel 4 is rotated in the reverse driving direction. Although the lens barrel 4 may be rotated back to some extent when the end of the frictional member 3 is shifted in the reverse driving direction, the lens barrel 4 is, on the whole, driven to move in the driving direction.

Alternatively, the coefficient of friction and the advance pressure of the frictional member 3 can be adjusted so that the end of the frictional member 3 slides on the lens barrel 4 both in the driving direction and in the reverse driving direction. In this case, the driving force applied to the lens barrel 4 is determined by the dynamic friction both when the lens barrel 4 is rotated in the driving direction and when the lens barrel 4 is rotated in the reverse driving direction. Even in this case, the levels of pressure applied by the frictional member 3 against the lens barrel 4 are different. The dynamic friction generated when the frictional member 3 is shifted in the driving direction is greater than the dynamic friction generated when the frictional member 3 is shifted in the reverse driving direction. Therefore, although the lens barrel 4 may be rotated back in the reverse driving direction to some degree, the lens barrel 4 is, on the whole, driven in the driving direction.

According to the example described above, the driving voltage waveforms take the shape of a sine wave, and such the signal waveforms whose the phases are shifted by 90 degrees from each other. However, the driving voltage waveforms are not limited to such a sine wave and the phases shift is not limited to 90 degrees.

### [Principle of Operation 2]

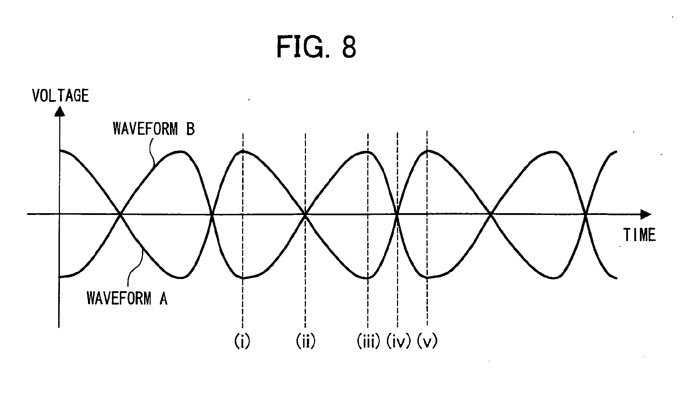

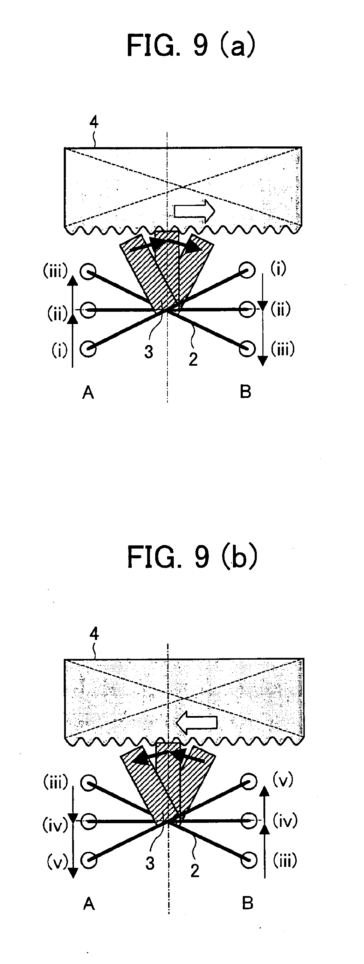

Explained next is another exemplary operation of driving the lens barrel 4, by use of the frictional member 3, to move in the optical axis direction. According to the foregoing operation, an end (i.e. the part in friction engagement with the lens barrel 4) of the frictional member 3 is driven to arc movement. Fig. 8 is a diagram showing waveforms of the driving voltages applied to the two flex movement members 1A and 1B. Figs. 9 (a) and 9 (b) are diagrams explaining how the end section of the frictional member 3 is driven to move along the arc in accordance with the driving voltage waveforms illustrated in Fig. 8. Figs. 9 (a) and 9 (b) show the present driving apparatus viewed in a direction represented by an arrow V.

According to Fig. 8, the waveform of the driving voltage applied to the flex movement member 1A is termed a waveform A, whereas the waveform of the driving voltage applied to the flex movement member 1B is termed a waveform B. Additionally, the driving voltage waveforms A and B are outputted from the driving circuits 7A and 7B respectively. As illustrated in Fig. 8, the waveforms A and B are sawtooth driving voltage waveforms, and the phases of the signal waveforms are set 180 degrees apart from each other. Figs. 9 (a) and 9 (b) show the positions of the connection points A and B with respect to moments (i) to (v) in the waveforms A and B in Fig. 8.

As illustrated in Figs. 9 (a) and 9 (b), when the flex movement members 1A and 1B are driven in accordance with the waveforms A and B, the connection points A and B are shifted in the numerical order from (i) to (v). Specifically, the connection points A and B lie: in the position (i) of Fig. 9 (a) at the moment (i) of Fig. 8; in the position (ii) of Fig. 9 (a) at the moment (ii) of Fig. 8; in the position (iii) of Figs. 9 (a) and 9 (b) at the moment (iii) of Fig. 8; in the position (iv) of Fig. 9 (b) at the moment (iv) of Fig. 8; and in the position (v) of Fig. 9 (b) at the moment (v) of Fig. 8. Since the connection points A and B are shifted through the transition from (i) to (v) as illustrated in Figs. 9 (a) and 9 (b), the end section of the frictional member 3 is driven to move along the arc as illustrated in Figs. 9 (a) and 9 (b).

The end of the frictional member 3 is driven to make the arc movement in accordance with the sawtooth driving voltage waveforms illustrated in Fig. 8. Consequently, the angular velocity in the driving direction and the angular velocity in the reverse driving direction are different (i.e. the angular velocity in the transition from (i) to (iii) is comparatively slow, whereas the angular velocity in the transition from (iii) to (v) is comparatively fast).

Furthermore, a difference can be generated between the angular acceleration of the frictional member 3 in the driving direction and the angular acceleration of the frictional member 3 in the reverse driving direction by suitably setting the driving voltage waveforms. Specifically, the driving voltage waveforms can be set so that the angular acceleration in the transition from (i) to (iii) (i.e. in the driving direction) is comparatively low, whereas the angular acceleration in the transition from (iii) to (v) (i.e. in the reverse driving direction) is comparatively high. As a result, the coefficient of friction of the frictional member 3 and the like can be adjusted so that, concerning the driving direction, the force applied to the point of contact between the frictional member 3 and the lens barrel 4 does not exceed the static friction between the frictional member 3 and the lens barrel 4. Thus, the end of the frictional member 3 does not slide on the lens barrel 4. In contrast, the coefficient of friction of the frictional member 3 and the like can be adjusted so that, concerning the reverse driving direction, the force applied to the point of contact between the frictional member 3 and the lens barrel 4 does exceed the static friction between the frictional member 3 and the lens barrel 4. Thus, the end of the frictional member 3 slides on the lens barrel 4. As a result, a difference is generated between the driving force in the driving direction and the driving force in the reverse driving direction, and the lens barrel 4 is therefore driven in the driving direction.

Alternatively, the coefficient of friction and the like can be adjusted so that the end of the frictional member 3 slides on the lens barrel 4 both in the driving direction and in the reverse driving direction. In this case, the driving force in the driving direction and the driving force in the reverse driving direction are equal and determined by the dynamic friction. Here, the period during which the end of the frictional member 3 is shifted in the driving direction is set long, and the period during which the end of the frictional member 3 is shifted in the reverse driving direction is set short in accordance with the driving voltage waveforms illustrated in Fig. 8. Therefore, the period during which the dynamic friction acts in the driving direction is longer than the period during which the dynamic friction acts in the reverse driving direction. As a result, the lens barrel 4 is driven in the driving direction.

The present driving apparatus can employ an arrangement in which the end of the frictional member 3 is in constant contact with the lens barrel 4. For example, by employing a spring as the elastic member 2, the frictional member 3 can be pressed against the lens barrel 4 with use of the spring. Alternatively, another arrangement is possible in which the flex movement members 1A and 1B are drawn toward the lens barrel 4 (i.e. in the direction of the driven body) to a predetermined extent and then fixed. Further alternatively, another arrangement is possible in which the guide shaft 5 is fixed so that the lens barrel 4 is pressed against the frictional member 3. According to the arrangements described above, the end of the friction member 3 is positioned so as to be in constant contact with the lens barrel 4 due to the advance pressure.

Furthermore, according to the arrangements described above, the frictional member 3 is excited so that, instead of making the arc rotational movement, the end of the frictional member 3 is linearly shifted, alternately in the driving direction and in the reverse direction (i.e. the reverse driving direction). (In this case, the flex movement members 1A and 1B, the elastic member 2, the frictional member 3 and the like are distorted.) It is needless to say that, even in the case, the lens barrel 4 can be driven in accordance with a principle similar to the principle explained in Principle of Operation 1.

Further, as described above, the elastic member is connected to the flex movement members 1A and 1B so that the imaginary line connecting the centers of the connection points A and B intersects (ideally at right angles) an imaginary line parallel with the length direction. Therefore, because of movement of the flex movement members 1A and 1B, the frictional member is driven so that the end of the frictional member makes the oval movement or the arc movement (or linearly in the case where the end of the frictional member is in constant contact with the lens barrel 4). As a result, the lens barrel is driven in the optical axis direction. Further, the two flex movement members 1A and 1B are disposed so as to form a corner (ideally having an angle of 90 degrees) by use of the connection section of the flex movement members 1A and 1B. As a result, the driving apparatus can be made compact and shortened in height. It is obvious that the flex movement members 1A and 1B are not necessarily disposed strictly along the side walls of the camera module housing 6 and can be disposed in a manner suitable for the space inside the camera module housing 6.

### [Second Embodiment]

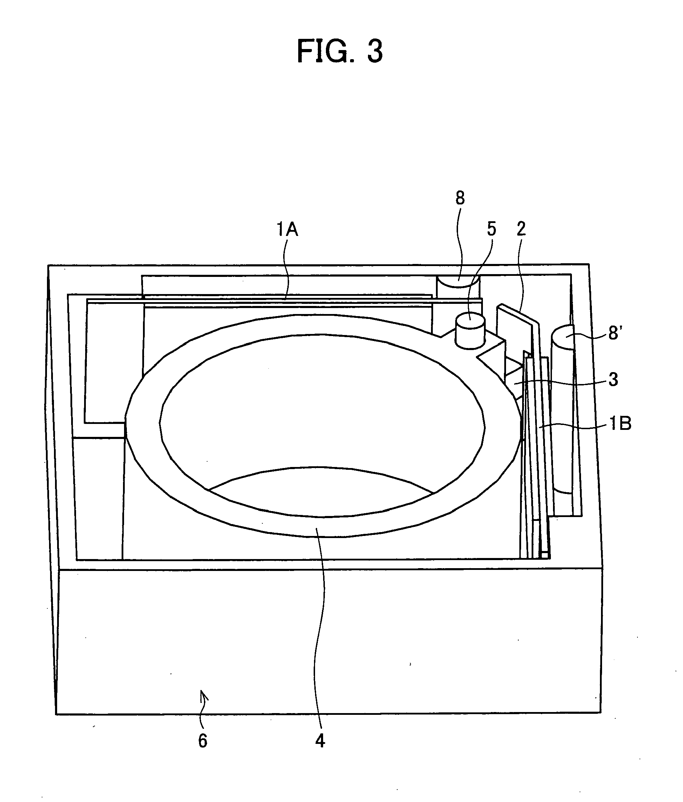

The following explains another embodiment of the present invention with reference to Fig. 3. Fig. 3 is a perspective view showing an arrangement of the driving apparatus (hereinafter referred to as the present driving apparatus) according to the present embodiment. It should be noted that, as a matter of practical convenience, in the case where a member of the present embodiment has the same function as another member has that is illustrated in the drawings concerning the first embodiment, the members are provided with the same code, and such a member of the present embodiment is not explained. Furthermore, the principle of operation of the present driving apparatus is identical to the principle of operation explained in the first embodiment and therefore is not explained.

According to the driving apparatus of the first embodiment, the protruding sections 8 are incorporated in the camera module housing 6. In comparison with this, as illustrated in Fig. 3, the present driving apparatus has an arrangement in which protruding sections 8' and the camera module housing 6 are separate members.

As illustrated in Fig. 3, the present driving apparatus has an arrangement in which the members that form the protruding sections 8' are adhered to side walls of the camera module housing 6. The material that form the protruding sections 8' is an elastic material or buffering material. According to general driving apparatus, the camera module housing 6 is made of resin or the like material which has relatively high rigidity so as to maintain the strength. Therefore, the protruding sections 8 provided in the driving apparatus of the first embodiment are formed from resin which has high rigidity. In contrast, the protruding sections 8' in the present driving apparatus are separate from the camera module housing 6, and formed from a shock-absorbing elastic material or buffering material. This makes it possible for the present driving apparatus to cushion impact caused by a collision, more effectively than the driving apparatus of the first embodiment.

### [Third Embodiment]

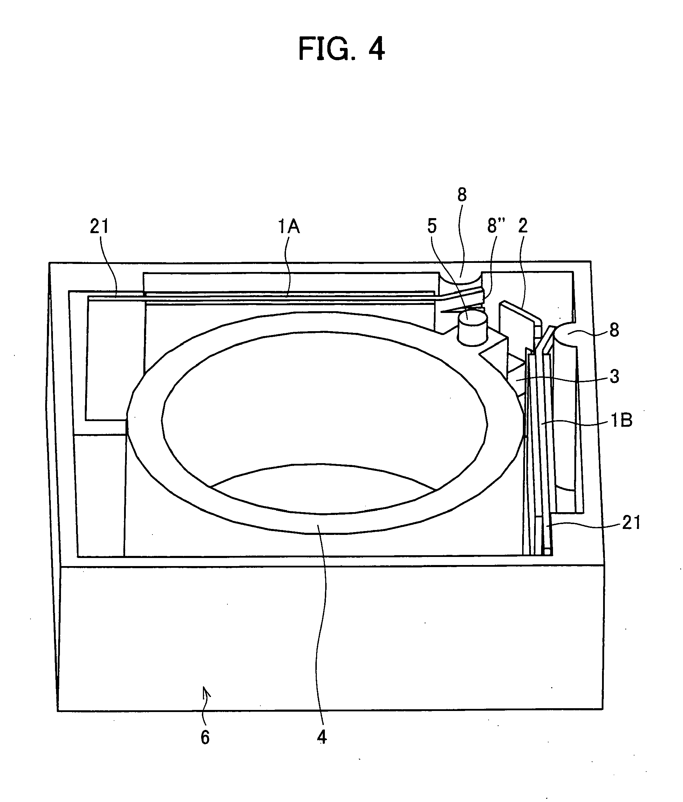

The following explains still another embodiment of the present invention with reference to Fig. 4. Fig. 4 is a perspective view showing an arrangement of the driving apparatus (hereinafter referred to as the present driving apparatus) according to the present embodiment. It should be noted that, as a matter of practical convenience, in the case where a member of the present embodiment has the same function as another member has that is illustrated in the drawings concerning the first embodiment, the members are provided with the same referential numerals, and explanation of such a member of the present embodiment is not repeated. Furthermore, the principle of operation of the present driving apparatus is identical to the principle of operation explained in the first embodiment and therefore is not explained repeatedly.

As illustrated in Fig. 4, the present driving apparatus has protruding sections 8" formed in the shims 21. The protruding sections 8" are formed by bending the shims 21 contained in the flex movement members 1A and 1B toward side walls of the camera module housing 6. Because of the bend, the protruding sections 8" have elasticity (a spring characteristic). Therefore, according to the present driving apparatus, in the case where the flex movement members 1A and 1B bend beyond the maximum flex movement amount, the shims 21 come into contact with the protruding sections 8 while being slowed down under the influence of the spring characteristic of the protruding sections 8". This makes it possible for the present driving apparatus to prevent the flex movement members 1A and 1B from being broken, in comparison with the driving apparatus of the first embodiment.

Explained so far is an exemplary case in which the present invention is applied to a focus adjusting mechanism of a compact camera module. However, the present invention is not limited to this. Any arrangement which has a driving apparatus having a flex movement member falls within the scope of the present invention.

The above embodiments illustrate an arrangement in which protruding sections are provided in the camera module housing 6, and another arrangement in which protruding sections are provided both in the camera module housing 6 and in the shims 2. However, the driving apparatus of the present invention is not limited to these. The driving apparatus of the present invention may have the protruding sections 8" solely in the shims 21.

The present invention is not limited to the description of the embodiments above, but may be altered by a skilled person within the scope of the claims. An embodiment based on a proper combination of technical means disclosed in different embodiments is encompassed in the technical scope of the present invention.

As described so far, a driving apparatus of the present invention includes the movement restricting means. In order to drive a driven body, the flex movement member needs to have a flex movement amount which falls within a certain range. When, among such flex movement amounts, the maximum movement degree is termed a maximum flex movement amount, the movement restricting means is disposed so as not to come into contact with the piezoelectric member in the flex movement member, in the case where the flex movement member bends beyond the maximum flex movement amount. Thus, it is possible to realize a driving apparatus in which; vibrational movement of the piezoelectric element is ensured; sufficient impact resistance is provided; and the piezoelectric element is prevented from being broken.

The driving apparatus of the present invention may be preferably arranged such that the movement restricting means restricts the excessive flex movement of the vibrational plate, the excessive flex movement being smaller than a tolerable flex movement amount of the vibrational plate, where the tolerable flex movement amount is a flex movement amount that the flex movement member is tolerable.

According to the above arrangement, in the case where the flex movement member bends beyond the maximum flex movement amount due to a collision or the like, the movement restricting means restricts the vibrational plate before the flex movement of the flex movement member reaches the tolerable flex movement amount. This makes it possible to prevent the piezoelectric member from being broken.

The driving apparatus of the present invention may include a support member which supports part of the flex movement member and includes a first protruding section as the movement restricting means, the first protruding section protruding toward the flex movement member.

In the driving apparatus of the present invention, the first protruding section is preferably disposed to come into contact with part of the vibrational plate without coming into contact with the piezoelectric member, when the flex movement member is making the excessive flex movement.

According to the above arrangement, in the case where the flex movement member bends beyond the maximum flex movement amount due to a collision or the like, the first protruding section comes into contact with part of the vibrational plate. When the foregoing happens, the first protruding section does not come into contact with the piezoelectric member of the flex movement member in the case where the flex movement member exhibits excessive flex movement. Thus, according to the above arrangement, it is possible to realize a driving apparatus in which; vibrational movement of the piezoelectric element is ensured; sufficient impact resistance is provided; and the piezoelectric element is prevented from being broken.

The driving apparatus of the present invention is preferably arranged such that the first protruding section is formed by an elastic material or a buffering material.

With this arrangement, in the case where the flex movement member bends beyond the maximum flex movement amount due to impact caused by a collision or the like, it is possible to cushion impact which is caused by a collision between the first protruding section and the vibrational plate.

Further, in the driving apparatus of the present invention, the vibrational plate may include a second protruding section as the movement restricting means.

Still further, in the driving apparatus of the present invention, the second protruding section preferably has an elastic structure.

According to the above arrangement, in the case where the flex movement member bends beyond the maximum flex movement amount, the vibrational plate is slowed down under the influence of the spring characteristic of the second protruding section. Consequently, the above arrangement makes it possible to prevent the flex movement member from being broken.

Yet further, the driving apparatus of the present invention may have an arrangement which includes first and second flex movement members serving as the flex movement members; and a driving member, which (a) is connected with the first and second flex movement members, (b) comes into contact with the driven body due to flex movement of the first and second flex movement members; and c) drives the driven body in a direction orthogonal to a flex movement direction of the flex movement members, the movement restricting means respectively for each of the first and second flex movement members.

The present driving apparatus can be made compact and shortened in height, and is thus applicable to the driving of such a lens in an optical apparatus as a camera lens.

The embodiments and concrete examples of implementation discussed in the foregoing detailed explanation serve solely to illustrate the technical details of the present invention, which should not be narrowly interpreted within the limits of such embodiments and concrete examples, but rather may be applied in many variations within the spirit of the present invention, provided such variations do not exceed the scope of the patent claims set forth below.

## Claims

1. A driving apparatus for driving a driven body (4), comprising:
a flex movement member (1A or 1B) for serving as a driving source to drive the driven body, the flex movement member including:
a piezoelectric member (22X or 22Y) which extends and contracts under electric control; and
a vibrational plate (21) which is larger than the piezoelectric member,
the piezoelectric member and the vibrational plate being attached to each other; and
movement restricting means (8) for restricting an excessive flex movement of the vibrational plate of the flex movement member, the movement restricting means being disposed at a position where the movement restricting means will not come into contact with the piezoelectric member of the flex movement member when the flex movement member is making an excessive flex movement beyond a maximum flex movement amount,
where the maximum flex movement amount is a greatest flex movement amount among flex movement amounts necessary for the flex movement member to drive the driven body.

2. The driving apparatus according to claim 1, wherein:
the movement restricting means (8) restricts the excessive flex movement of the vibrational plate (21), the excessive flex movement being smaller than a tolerable flex movement amount of the flex movement member,
where the tolerable flex movement amount is a flex movement amount that the flex movement member (1A or 1B) is tolerable.

3. The driving apparatus according to claim 1 or 2, further comprising:
a support member (6) which supports part of the flex movement member and includes a first protruding section (8) as the movement restricting means (8), the first protruding section protruding toward the flex movement member (1A or 1B).

4. The driving apparatus according to claim 3, wherein the first protruding section (8) is disposed to come into contact with part of the vibrational plate (21) without coming into contact with the piezoelectric member (22X or 22Y), when the flex movement member (1A or 1 B) is making the excessive flex movement.

5. The driving apparatus according to claim 3 or 4, wherein the first protruding section (8) is formed by an elastic material or a buffering material.

6. The driving apparatus according to any one of claims 1 to 5, wherein the vibrational plate includes a second protruding section (8") as the movement restricting means (8).

7. The driving apparatus according to claim 6, wherein the second protruding section (8") has an elastic structure.

8. The driving apparatus according to any one of claims 1 to 7, comprising:
first and second flex movement members (1A and 1 B) serving as the flex movement members; and
a driving member (2 and 3), which
(a) is connected with the first and second flex movement members,
(b) comes into contact with the driven body (4) due to flex movement of the first and second flex movement members; and
(c) drives the driven body in a direction orthogonal to a flex movement direction of the flex movement members,
the movement restricting means (8) respectively for each of the first and second flex movement members.
